# EUROPÄISCHE PATENTSCHRIFT

(11) **EP 4 211 478 B1**
(45) Veröffentlichungstag und Bekanntmachung des Hinweises auf die Patenterteilung: **07.08.2024**
(21) Anmeldenummer: 21805860.0
(22) Anmeldetag: 28.10.2021
(51) Int. Cl.: G01R 31/327, G05B 19/042

(54) **AUSGABEBAUGRUPPE UND VERFAHREN ZUM BETRIEB**
OUTPUT MODULE AND METHOD FOR OPERATION
MODULE DE SORTIE ET PROCÉDÉ DE FONCTIONNEMENT

(30) Priorität: 01.12.2020 EP 20210889
(43) Veröffentlichungstag der Anmeldung: 19.07.2023
(73) Patentinhaber: Siemens Aktiengesellschaft, 80333 München (DE)
(72) Erfinder: FISCHER, Peter, 92421 Schwandorf (DE); DEHLING, Fabian, 92265 Edelsfeld (DE)
(74) Vertreter: Siemens Patent Attorneys
(86) Internationale Anmeldenummer: PCT/EP2021/079914
(87) Internationale Veröffentlichungsnummer: WO 2022/117266

(56) Entgegenhaltungen:
- JP-A- 2011 186 518
- KR-A- 20150 074 653

## Beschreibung

Die Erfindung betrifft eine Ausgabebaugruppe mit einem Ausgang zum Schalten einer Last, umfassend ein Schaltmittel, welches an den Ausgang eine Schaltspannung schaltet und damit ein Laststrom fließt.

Auch betrifft die Erfindung ein Verfahren zum Betrieb einer Ausgabebaugruppe, wobei ein Schaltmittel an einen Ausgang zum Schalten einer Last eine Schaltspannung schaltet und damit ein Laststrom fließt.

Derartige Ausgabebaugruppen sind beispielsweise aus der EP 2 549 843 A1 bekannt. Insbesondere in der industriellen Automatisierungstechnik bzw. der Steuerungstechnik werden Ausgabebaugruppen benötigt, welche beispielsweise Aktoren, Relais oder magnetische Ventile Schalten.

Bei der Ausgabebaugruppe gemäß EP 2 549 843 A1 wird ein Verfahren vorgestellt, bei welchen ein einmalig gesteckter Steckverbinder wieder sicher einer Ausgabebaugruppe zugeordnet werden kann.

Derartig bekannte digitale Ausgabebaugruppen von beispielsweise speicherprogrammierbare Steuerungen zur Ansteuerung von z.B. elektromagnetischen Lasten bzw. induktiven Lasten, ohmschen oder kapazitiven Lasten überwachen lediglich ein Ausgangssignal auf einen eingestellten statischen Wert bezüglich Kurzschluss/Überlast und/oder Drahtbruch. Bei einem Überschreiten eines Grenzwertes sendet die Baugruppe ein Diagnosesignal an ein übergeordnetes System.

In der KR 2015 0074653 A und in der JP 2011 186518 A werden Ausgabebaugruppen offenbart, welche in der Lage sind anhand des Signalverlaufes des Laststroms durch eine Spule auf einen Verschleiß zu schließen.

Damit wird eine durch Verschleiß oder Verschmutzung bedingte Änderung des Signalverlaufes beim Schalten eines Verbrauchers erkannt. Ein möglicher Wartungshinweis kann somit generiert werden, was wiederum nicht zu Ausfällen der Anlage führt und somit keine hohe Kosten verursacht.

Es ist die Aufgabe der Erfindung die bekannten Ausgabebaugruppen zu verbessern, dass ein frühzeitiger Verschleiß von zu schaltenden Lasten erkannt wird.

Die Aufgabe wird dadurch gelöst, dass für die eingangs genannte Ausgabebaugruppe ein Messmittel vorhanden ist, welches ausgestaltet ist, zum Bereitstellen eines Überwachungs-Signalverlaufs, welcher einen Signalverlauf des Laststromes aufgrund der Schaltspannung abbildet, weiterhin aufweisend ein Analysemittel, ausgestaltet den Überwachungs-Signalverlauf mit einer die Last charakterisierenden Einschaltkennlinie zumindest punktuell zu vergleichen, und weiterhin aufweisend ein Diagnosemittel, welches ausgestaltet ist, eine Wartungsmeldung zu generieren, wenn der Vergleich eine vorgebbare Abweichung überschreitet.

Für eine schnelle und effektive Analyse weist die Ausgabebaugruppe ein Erfassungsmittel auf, welches ausgestaltet ist, bei einer erstmaligen Inbetriebnahme der Last einen Anfangszustand und damit eine Individual-Einschaltkennlinie der Last über einen vorbestimmten Erfassungszeitraum mit einer vorbestimmten Abtastrate zu erfassen, weiterhin ist das Erfassungsmittel dazu ausgestaltet, für den punktuellen Vergleich aus der Individual-Einschaltkennlinie Wertepaare zu ermitteln und abzuspeichern, bei denen eine Steigung im Verlauf der Individual-Einschaltkennlinie das Vorzeichen wechselt oder Null ist, wobei die Wertepaare eine Amplitude und einen Zeitpunkt aufweisen, dass Messmittel ist dann ausgestaltet, ebenfalls in dem vorbestimmten Erfassungszeitraum mit der vorbestimmten Abtastrate den Überwachungs-Signalverlauf bereitzustellen, weiterhin ist das Analysemittel ausgestaltet, für den punktuellen Vergleich aus dem Überwachungs-Signalverlauf aktuelle Wertepaare zu ermitteln bei denen ebenfalls eine Steigung im Verlauf des Überwachungs-Signalverlaufs das Vorzeichen wechselt oder Null ist, weiterhin ist das Analysemittel dazu ausgestaltet, die Wertepaare mit den aktuellen Wertepaaren hinsichtlich einer Verschiebung ihres Zeitpunktes hin zu untersuchen, und bei Überschreiten einer vorgebbaren Abweichung die Wartungsmeldung zu generieren.

Mit Vorteil kann nun ein aktuell aufgenommener Überwachungs-Signalverlauf, beispielsweise eines elektromagnetischen Schalters (Schütz), mit einem Sollverlauf einer Kennlinie, beispielsweise für ein fabrikneues Schütz, verglichen werden. Sollten Abweichungen zwischen dem aktuell aufgenommenen Überwachungs-Signalverlauf und dem Signalverlauf eines neuen Aktors entstehen, kann daraus geschlossen werden, dass die zu schaltende Last gealtert ist oder bald ausgetauscht werden muss.

Eine weitere Verbesserung der Ausgabebaugruppe sieht vor, dass das Analysemittel ausgestaltet ist, eine Höhe einer Versorgungsspannung der Ausgabebaugruppe zu ermitteln und bei einem Vergleich des Überwachungs-Signalverlaufs mit der Einschaltkennlinie die Höhe der Versorgungsspannung derart zu berücksichtigen, dass es bei Schwankungen in der Versorgungsspannung, welche sich ebenfalls auf die Schaltspannung und damit auf den Überwachungs-Signalverlauf auswirken, nicht zu einer fälschlicherweise generierten Wartungsmeldung kommt.

In Abhängigkeit der Höhe der Versorgungsspannung ändern sich auch die Amplitudenwerte des Überwachungs-Signalverlaufs bzw. der ausgegebenen Schaltspannung. Bei einem Vergleich könnten diese Veränderungen wiederum zu einer falschen Information bzw. einer irrtümlichen Wartungsmeldung führen. Bei derzeit bekannten Ausgabebaugruppen kann die Versorgungsspannung in einem Bereich von 20,4 V bis 28,8 V rangieren und trotzdem wird ein sicherer Betrieb gewährleistet. Aber diese große Schwankung der Versorgungsspannung hat auch zur Folge, dass die Schaltspannung für die entsprechend zu schaltenden Last ebenfalls diesen Schwankungen unterliegt. Um zwischen einer Veränderung aufgrund z.B. eines mechanischen Verschleißes oder einer Veränderung der Versorgungsspannung differenzieren zu können, wird die Amplitude der Versorgungsspannung in eine Analyse des Überwachungs-Signalverlaufs mit einbezogen.

Um für einen Vergleich zwischen einer ursprünglichen Einschaltkennlinie und den nachfolgenden aufgenommenen Überwachungs-Signalverläufen einen zu verwendeten Speicherbedarf zu optimieren, werden lediglich die Amplitudenwerte, bezogen auf die Zeitachse, zwischengespeichert, bei denen sich die Steigung des Signalverlaufes signifikant ändert.

Neben dem Vorteil der Speicherplatzersparnis ist dieser punktuelle Vergleich mit Wertepaaren wesentlich schneller und effizienter in einem Algorithmus zu programmieren, so dass die Auswertung der Signalverläufe leistungsstärker ist.

Weiter ist es vom Vorteil, dass mit dem Vergleich der Wertepaare eine Möglichkeit geschaffen wurde, den Einfluss der Höhe der Versorgungsspannung zu berücksichtigen, denn in der Regel wirkt sich die Versorgungsspannung derart aus, dass die Amplitudenwerte des Signalverlaufes in der Regel um einen gewissen Betrag erhöht sind. Das bedeutet, dass die signifikanten Stellen im Signalverlauf, an denen sich die Steigung ändert, also wo Extremwerte im Signalverlauf entstehen, bei einem nicht signifikanten Verschleiß zeitlich an der gleichen Stelle sind. Somit kann der Einfluss der Versorgungsspannung berücksichtigt werden ohne dass es zu einer fälschlicherweise abgesetzten Wartungsmeldung kommt.

Dieser punktuelle Vergleich des Signalverlaufes kann insbesondere bei induktiven Lasten für elektromechanische Stellglieder angewendet werden. Das Analysemittel ist dann ausgestaltet, in Bezug auf eine induktive Last eines elektromechanischen Stellgliedes mit einer Spule und einem Anker in den Überwachungs-Signalverlauf folgende Werte zu ermitteln, ausgehend von einem Startzeitpunkt, bei welchen eine Bestromung der Spule beginnt, wird bei Erreichen eines ersten Zeitpunktes, bei welchem sich der Anker bewegt, ein erster Vergleichswert, bei Erreichen eines zweiten Zeitpunktes, bei welchem der Anker eine Endlage erreicht, wird ein zweiter Vergleichswert ermittelt und bei Erreichen eines dritten Zeitpunktes, bei welchem eine magnetische Sättigung erreicht ist, wird ein dritter Vergleichswert ermittelt. Diese ermittelten Vergleichswerte bilden beispielsweise einen einen Signalverlauf charakterisierenden "Dreipunkte-Verlauf", welche im Hinblick auf das Generieren einer Wartungsmeldung, insbesondere für konstruktive Lasten, ausreichend ist. Für eine andere Art von Last können auch vier oder mehr Punkte verwendet werden.

Weiterhin ist das Analysemittel ausgestaltet, eine Zeitdauer zwischen dem ersten Zeitpunkt und dem zweiten Zeitpunkt zu ermitteln und als ein Verschleißkriterium zu werten und eine Wartungsmeldung zu generieren, wenn die Zeitdauer eine vorgegebene Zeitdauer überschreitet.

Mit Vorteil weist die Ausgabebaugruppe einen Zwischenspeicher auf, der ausgestaltet ist, zum Speichern von Überwachungs-Signalverläufen und Weiterleiten an ein übergeordnetes System. Bezogen auf die Ermittlung der drei Vergleichspunkte, wird der sogenannte Dreipunkt-Verlauf erfasst und ebenfalls zwischengespeichert und später an ein übergeordnetes System weitergeleitet, welches dann aus dem Dreipunkt-Verlauf den charakteristischen Signalverlauf des Überwachungs-Signalverlaufes herauslesen kann. Mit dieser Vorgehensweise kann eine zu speichernde und zu übertragende Datenmenge stark reduziert werden. Sind genug Speicher und Rechenkapazitäten vorhanden können der komplette Signalverlauf und/oder der Dreipunkt-Verlauf übertragen werden.

Insbesondere im Hinblick auf moderne Schütze, welche mit einer PWM-Ansteuerung zur Leistungsreduzierung ausgestaltet sind, ist es von Vorteil, wenn die Baugruppe einen Filter aufweist, welcher zur Berechnung eines geglätteten Signalverlaufs ausgebildet ist, falls der Überwachungs-Signalverlauf als gepulster Signalverlauf vorliegt.

Ebenfalls wird die eingangs genannte Aufgabe durch ein Verfahren zum Betrieb einer Ausgabebaugruppe gelöst, wobei ein Schaltmittel an einen Ausgang zum Schalten einer Last eine Schaltspannung schaltet und damit ein Laststrom fließt, verfahrensgemäß wird ein Überwachungs-Signalverlauf ermittelt, welcher einen Signalverlauf des Laststromes aufgrund der Schaltspannung abbildet, der Überwachungs-Signalverlauf wird derart analysiert, dass er mit einer die Last charakterisierenden Einschaltkennlinie zumindest punktuell verglichen wird, es wird ein Diagnosemittel derart betrieben, eine Wartungsmeldung zu generieren, wenn der Vergleich eine vorgebbare Abweichung überschreitet. Hat man beispielsweise ein Relais in einem Neuzustand und erfasst seinen Einschalt-Kennlinienverlauf, dann ist in einem Vergleich dieser annähernd dem Einschalt-Kennlinienverlauf eines fabrikneuen Relais. Aber sollte ein Überwachungs-Signalverlauf nach beispielsweise 3 Millionen Schaltspielen des Relais aufgenommen werden, so kann man in dem Überwachungs-Signalverlauf Verzögerungen oder veränderte Amplitudenwerte ablesen, welche auf eine Alterung oder einen Verschleiß des Relais hindeuten. Mittels eines Erfassungsmittels wird bei einer erstmaligen Inbetriebnahme der Last ein Anfangszustand und damit eine Individual-Einschaltkennlinie der Last über einen vorbestimmten Erfassungszeitraum mit einer vorbestimmten Abtastrate erfasst, weiterhin werden für den punktuellen Vergleich aus der Individual-Einschaltkennlinie Wertepaare ermittelt und abgespeichert, bei denen eine Steigerung im Verlauf der Individual-Einschaltkennlinie das Vorzeichen wechselt oder Null ist, wobei die Wertepaare eine Amplitude und einen Zeitpunkt aufweisen, mit dem Messmittel wird dann ebenfalls in dem vorbestimmten Erfassungszeitraum mit der vorbestimmten Abtastrate der Überwachungs-Signalverlauf bereitgestellt, weiterhin werden für den punktuellen Vergleich aus dem Überwachungs-Signalverlauf aktuelle Wertepaare ermittelt bei denen ebenfalls eine Steigung im Verlauf des Überwachungs-Signalverlaufs das Vorzeichen wechselt oder Null ist, die Wertepaare aus der Individual-Einschaltkennlinie werden mit dem aktuellen Wertepaaren hinsichtlich einer Verschiebung ihres Zeitpunktes hin verglichen, und bei Überschreiten einer vorgegebenen Abweichung wird die Wartungsmeldung generiert.

Derzeit bekannte Baugruppen können eine durch Verschleiß oder Verschmutzung bedingte Änderung des Signalverlaufes beim Schalten eines Verbrauchers nicht erkennen. Dementsprechend wird ein möglicher Wartungshinweis nicht generiert, was wiederum zu Ausfällen von industriellen Anlagen führen kann. Dem gegenüber ist nun verfahrensgemäß ein Betrieb einer Ausgabebaugruppe dargestellt, welche dazu führt, frühzeitig eine Wartungsmeldung bei einem drohenden Verschleiß oder einer Verschmutzung auszugeben.

Dazu wird ein Analysemittel betrieben, welches in der Lage ist, eine Höhe einer Versorgungsspannung der Ausgabebaugruppe zu ermitteln und bei einem Vergleich des Überwachungs-Signalverlaufs mit der Einschalt-Kennlinie die Höhe der Versorgungsspannung derart zu berücksichtigen, dass es bei Schwankungen in der Versorgungsspannung, welche sich ebenfalls auf die Schaltspannung und damit auf den Überwachungs-Signalverlauf auswirken, nicht zu einer fälschlicherweise generierten Wartungsmeldung kommt.

Heute bekannte Ausgabebaugruppen, insbesondere für die industrielle Automatisierung, haben einen Versorgungsspannungsbereich von beispielsweise 20,4 bis 28,8 Volt und bei unterschiedlichen Anlagen kann die Versorgungsspannung unterschiedlich ausfallen.

Mit dieser Vorgehensweise kann insbesondere ein Einfluss einer Versorgungsspannung leicht ermittelt werden bzw. derart herausgerechnet werden, dass es nicht zu fälschlicherweise abgesetzten Wartungsmeldungen kommt. Denn, bei einem intakten Schütz wird der Amplitudenwert von Extremwerten bei den einen und den anderen Signalverlauf sich nur in der Höhe unterscheiden und der Zeitpunkt der Extremwerte bleibt gleich. Und wenn sich der Extremwert nicht zu anderen Zeitpunkten hin verschoben hat, kann man davon ausgehen, dass kein Verschleiß an den Bauteilen vorliegt, sondern nur die Versorgungsspannung beeinflusst wurde.

Insbesondere in Bezug auf eine induktive Last eines elektromagnetischen Stellgliedes mit einer Spule und einem Anker hat es sich als vorteilhaft herausgestellt in dem Überwachungs-Signalverlauf folgende Werte zu ermitteln, ausgehend von einem Startzeitpunkt, bei welchem eine Bestromung der Spule beginnt, wird bei Erreichen eines ersten Zeitpunktes, bei welchem sich der Anker bewegt, ein erster Vergleichswert, bei Erreichen eines zweiten Zeitpunktes, bei welchem der Anker eine Endlage erreicht, wird ein zweiter Vergleichswert ermittelt und bei Erreichen eines dritten Zeitpunktes, bei welchem eine magnetische Sättigung erreicht ist, wird ein dritter Vergleichswert ermittelt.

Zusätzlich kann eine Zeitdauer zwischen dem ersten Zeitpunkt und dem zweiten Zeitpunkt ermittelt werden und als ein Verschleißkriterium gewertet werden und eine Wartungsmeldung wird generiert, wenn die Zeitdauer eine vorgebbare Zeitdauer überschreitet.

Im Hinblick auf eine vorbeugende Wartung einer Gesamtanlage werden die Überwachungs-Signalverläufe auf der Ausgabebaugruppe zwischengespeichert und an ein übergeordnetes System weitergegeben. Um Speicherplatz zu sparen können auch nur die Vergleichswerte als ein Dreipunkte-Verlauf abgespeichert werden.

Zur Früherkennung werden einem Anlagenbetreiber Wartungsdaten zur Verfügung gestellt.

Die erfindungsgemäße Ausgabebaugruppe mit ihrem Analysemittel zum Analysieren des aufgenommenen Überwachungs-Signalverlaufs kann auch zur Aufzeichnung von Analyse der Versorgungsspannung, zur Aufzeichnung und Analyse der Ausgangsströme von mehreren Kanälen bei einer mehrkanaligen Ausgabebaugruppe verwendet werden. Eine Analyse der Last könnte auch in Bezug auf einem Gleichstrommotor die Drehzahl betreffen. Eine Strommessung würde in die Analyse beispielsweise bei ohmschen Verbrauchern mit einbezogen werden. Es könnten so z.B. korridierte Klemmstellen aufgedeckt werden. Die Analyse beinhaltet die Erkennung von blockierten elektromechanischen Schützen oder Magnetventilen.

Im Hinblick auf eine gepulste Spannung ist im Sinne der Erfindung eine Pulsweitenmodulation-Ansteuerung (PWM) zu verstehen. PWM-Ansteuerungen sind heutzutage weit verbreitet. Viele Steuergeräte haben PWM-Routinen bereits implementiert. Mittels PWM lässt sich auch bei Relaisspulen die Spulenleistung reduzieren und damit die Erwärmung des Relais verhindern.

Im Sinne der Erfindung ist es vorgesehen, Signalverläufe bzw. Signalmuster, welche Schadens-, Verschleiß- oder Fehlzustände bereits im Vorfeld anzeigen, zu analysieren und daraus Wartungsmeldungen zu generieren.

Die Zeichnung zeigt ein Ausführungsbeispiel der Erfindung. Dabei zeigt:
- FIG 1: eine Ausgabebaugruppe zum Schalten einer Last,
- FIG 2: einen typischen Stromverlauf einer induktiven Last,
- FIG 3: einen Kennlinienverlauf mit einem aufgenommenen Überwachungs-Signalverlauf zum Vergleich mit einer Einschaltkennlinie,
- FIG 4: einen Signalverlauf zur Verdeutlichung der Auswirkungen der Schaltspannung auf die Überwachungs-Signalverläufe und
- FIG 5: Signalverläufe für zwei unterschiedliche Versorgungsspannungen.

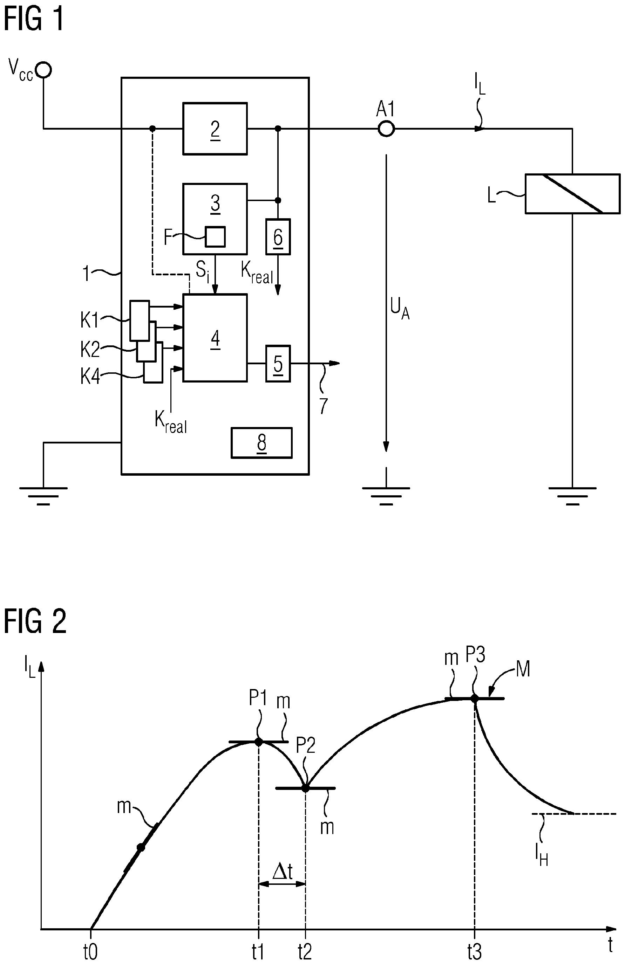

Gemäß FIG 1 ist eine Ausgabebaugruppe mit einem Ausgang A1 zum Schalten einer Last L dargestellt. Die Ausgabebaugruppe umfasst ein Schaltmittel 2, welches an den Ausgang A1 eine Schaltspannung UA schaltet und damit einen Laststrom I_{L} durch die Last L fließt. Derartige Ausgabebaugruppen werden beispielsweise in der industriellen Automatisierungstechnik zum Schalten von Relais oder Magnetventilen genutzt.

Ein Messmittel 3 in der Ausgabebaugruppe 1 ist ausgestaltet, einem Überwachungs-Signalverlauf Sᵢ, welcher einem Signalverlauf des Laststromes I_{L} durch die Last L aufgrund der Schaltspannung U_{A} abbildet, aufzunehmen. Diese Aufnahme könnte beispielsweise folgendermaßen ausgeführt sein. Mit dem Aktivieren des Ausgangs A1 erfolgt über einen Stromspiegel eine Abtastung des Signals mittels eines Analog-Digital-Wandlers. Dabei wird der Signalverlauf mit einer vorher definierten Abtastfrequenz über eine vorher definierte Zeit t erfasst und der Ausgabebaugruppe 1 bzw. einem Analysemittel 4 zur weiteren Bearbeitung/Analyse zur Verfügung gestellt.

Das Analysemittel 4 ist ausgestaltet, den Überwachungs-Signalverlauf Sᵢ mit einer die Last L charakterisierenden Einschaltkennlinie K1 zumindest punktuell zu vergleichen.

Die Vergleichswerte werden einem Diagnosemittel 5 zugeführt, welches ausgestaltet ist, eine Wartungsmeldung zu generieren, wenn der Vergleich eine vorgebbare Abweichung überschreitet.

Das Analysemittel 4 bekommt als Eingangsgröße den Überwachungs-Signalverlauf Si des jeweils aufgenommenen Stromes der Last L und als weitere Überwachungsgröße unterschiedliche Einschaltkennlinien, nämlich eine erste Einschaltkennlinie K1, eine zweite Einschaltkennlinie K2 und eine dritte Einschaltkennlinie K3, für unterschiedliche Lasten und/oder Versorgungsspannung V_{CC}. Auch ist die Ausgabebaugruppe 1 dazu ausgestaltet, bei einer erstmaligen Inbetriebnahme der Last L einen Anfangszustand und damit eine Individual-Einschaltkennlinie Kᵣₑₐₗ der Last L zu erfassen. Auch diese Individual-Einschaltkennlinie Kᵣₑₐₗ wird als Eingangsgröße dem Analysemittel 4 zur Verfügung gestellt.

Im Hinblick auf ein zu schaltendes Relais mit einer integrierten PWM-Ansteuerung weist die Ausgabebaugruppe 1, vorzugsweise in dem Messmittel 3, einen Filter F auf. Der Filter F dient zur Berechnung eines geglätteten Signalverlaufs, falls der Überwachungs-Signalverlauf Sᵢ als gepulster Signalverlauf vorliegen sollte.

Die Ausgabebaugruppe 1 gemäß FIG 1 ist insbesondere dazu ausgestaltet, in Bezug auf eine induktive Last L eines elektromechanischen Stellgliedes mit einer Spule und einem Anker in dem aufgenommenen Überwachungs-Signalverlauf Sᵢ Vergleichswerte zu ermitteln. Für die Erklärung der zu ermittelnden Werte wird auf die FIG 2 verwiesen.

FIG 2 zeigt einen typischen Stromverlauf einer zu schaltenden induktiven Last L. Ausgehend von einem Startzeitpunkt t0, bei welchem eine Bestromung der Spule beginnt, wird bei Erreichen eines ersten Zeitpunktes t1, bei welchem sich der Anker bewegt, ein erster Vergleichswert P1, bei Erreichen eines zweiten Zeitpunktes t2, bei welchem der Anker eine Endlage erreicht, wird ein zweiter Vergleichswert P2 ermittelt und bei Erreichen eines dritten Zeitpunktes t3, bei welchem eine magnetische Sättigung erreicht ist, wird ein dritter Vergleichswert P3 ermittelt. Nach dem Erreichen des dritten Vergleichswertes t3 sinkt der Signalverlauf des Laststromes I_{L} ab und wird in einen Haltestrombereich I_{H} geführt. Das Analysemittel 4 der Ausgabebaugruppe 1 ist für den punktuellen Vergleich ausgestaltet, die Vergleichswerte P1,P2,P3 an den Stellen zu ermitteln, bei denen eine Steigung m im Überwachungs-Signalverlauf Sᵢ das Vorzeichen wechselt oder Null ist. Auch ist das Analysemittel 4 der Ausgabebaugruppe 1 ausgestaltet, eine Zeitdauer Δt zwischen dem ersten Zeitpunkt t1 und dem zweiten Zeitpunkt t2 zu ermitteln und als ein Verschleißkriterium zu werten und eine Wartungsmeldung 7 zu generieren, wenn die Zeitdauer Δt eine vorgebbare Zeitdauer tₙₑᵤ überschreitet. Mit zunehmender Alterung, beispielsweise eines Schaltrelais oder Schützes, wird sich die Zeit Δt immer weiter vergrößern.

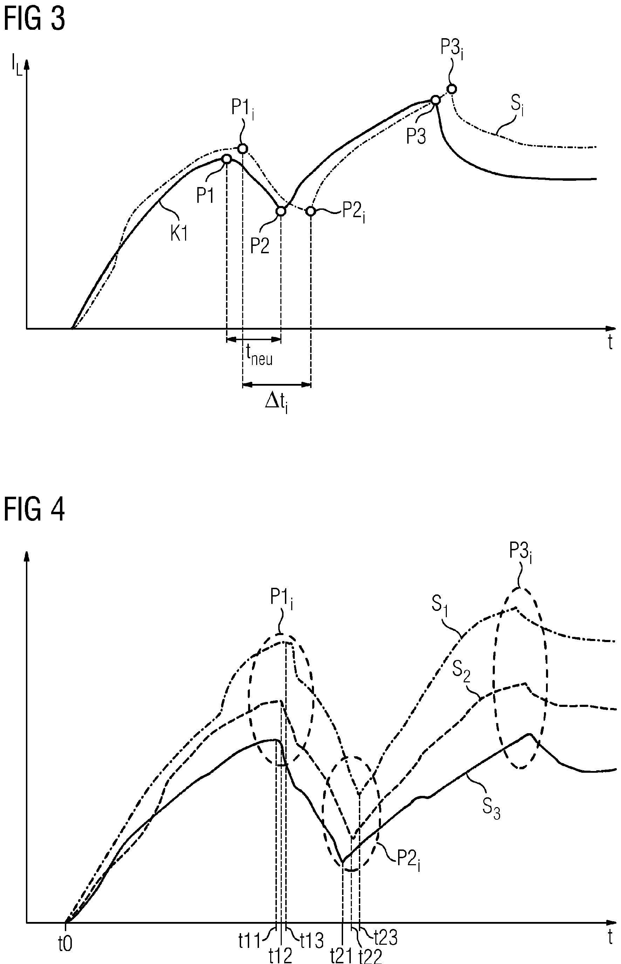

Die FIG 3 zeigt einen Vergleich einer Einschaltkennlinie K1 mit einem aktuell aufgenommenen Überwachungs-Signalverlauf Sᵢ. Die Vergleichswerte P1,P2,P3 werden mit den entsprechenden Vergleichswerten P1i,P2i,P3i des entsprechenden Überwachungs-Signalverlauf Sᵢ verglichen. Auch wird die Verschiebung oder Vergrößerung der Zeitdauer Δt zwischen dem ersten Zeitpunkt t1 und dem zweiten Zeitpunkt t2 ermittelt und analysiert.

Die FIG 4 zeigt unterschiedliche Überwachungs-Signalverläufe bei unterschiedlichen Versorgungsspannungen V_{CC}. Ein erster Überwachungs-Signalverlauf S₁ ist bei einer ersten Versorgungsspannung V1 aufgenommen worden, ein zweiter Überwachungs-Signalverlauf S₂ ist bei einer zweiten Versorgungsspannung V2 und ein dritter Überwachungs-Signalverlauf S₃ ist bei einer dritten Versorgungsspannung V3 aufgenommen worden. Das Analysemittel 4 der Baugruppe 1 ist nun ausgestaltet, eine Höhe der Versorgungsspannung V_{CC} der Ausgabebaugruppe 1 zu ermitteln und bei einem Vergleich der Überwachungs-Signalverläufe S₁,S₂,S₃ mit einer jeweiligen Einschaltkennlinie K1i, welche die Höhe der entsprechenden Versorgungsspannung repräsentiert, zu vergleichen und derart zu berücksichtigen, dass es bei Schwankungen in der Versorgungsspannung V_{CC}, welche sich ebenfalls auf die Schaltspannung U_{A} und damit auf dem Überwachungs-Signalverlauf Sᵢ auswirken, nicht zu einer fälschlicherweise generierten Wartungsmeldung 7 kommt.

Im Hinblick auf eine speicherplatzschonende Abspeicherung, insbesondere auf der Baugruppe, wird pro Signalverlauf nur ein sogenannter Dreipunkt-Verlauf gemerkt. Die gestrichelten Linien zeigen einen Bereich für die Erfassung von ersten, zweiten und dritten Vergleichswerten P1ᵢ,P2ᵢ und P3ᵢ.

Gemäß FIG 4 ist den Amplituden-Extremwerten der Signalverläufe S1,S2,S3 jeweils ein erster Zeitpunkt t11,t12,t13 und ein zweiter Zeitpunkt t21,t22,t23 zugeordnet. Hieraus ist bereits ersichtlich, dass ein Einfluss der Versorgungsspannung VCC auf die Signalverläufe S1,S2,S3 zwar eine bedeutende Auswirkung auf den Amplitudenwert hat, nicht aber auf den zugehörigen Zeitwert.

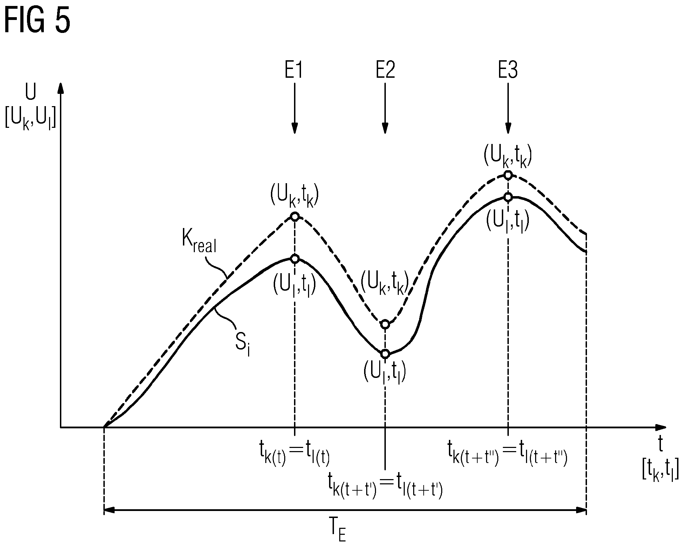

Mit der FIG 5 soll verdeutlicht werden, wie man aus dem Signalverläufen Extremwerte E1,E2,E3 analysieren kann und anhand der zu den Extremwerten E1,E2,E3 zugehörigen Wertepaare U_{K},t_{K} bzw. U_{L},t_{L} kann eine Aussage darüber getroffen werden, ob ein Verschleiß vorliegt oder nicht. Über der Zeit t wird in einen vorbestimmten Erfassungszeitraum T_{E} mit einer vorbestimmten Abtastrate der Signalverlauf erfasst. Für den späteren punktuellen Vergleich der der Wertepaare wird aus der Individual-Einschaltkennlinie Kᵣₑₐₗ jeweils ein dem Extremwert E1,E2,E3 zugehöriges Wertepaar U_{K},t_{K} ermittelt und abgespeichert. Um einen Extremwert E1,E2,E3 im Verlauf der Individual-Einschaltkennlinie Kᵣₑₐₗ herauszufinden, wird die Steigung m des Signalverlaufes untersucht.

Die Wertepaare U_{K},t_{K} weisen bei den Extremwerten E1,E2,E3 jeweils eine Amplituden U_{K} und einen Zeitpunkt t_{K} auf.

Mit dem Messmittel 3 wird dann ebenfalls in dem vorbestimmten Erfassungszeitraum T_{E} mit der vorbestimmten Abtastrate der Überwachungs-Signalverlauf Sᵢ bereitgestellt. Für den späteren punktuellen Vergleich werden aus dem Überwachungs-Signalverlauf Si aktuelle Wertepaare U_{L},t_{L} ermittelt, bei denen ebenfalls eine Steigung m im Laufe des Überwachungs-Signalverlaufs Sᵢ das Vorzeichen wechselt oder Null ist. Die Wertepaare U_{K},t_{K}, aus der Individual-Einschaltkennlinie Kᵣₑₐₗ werden mit den aktuellen Wertepaaren U_{L},t_{L} hinsichtlich einer Verschiebung ihres Zeitpunktes hin verglichen, und bei Überschreiten einer vorgebbaren Abweichung wird die Wartungsmeldung 7 generiert.

Die beiden Signalverläufe gemäß FIG 5 unterscheiden sich nur in ihren maximalen Amplitudenwerten, so wird bei einem ersten Extremwert E1 zu einem Zeitpunkt t_{K (t)} = t_{L(t)} sich nur die jeweilige Amplitude U_{K},U_{L} unterscheiden und zu einem zweiten Extremwert E2 zum Zeitpunkt t_{K} (t+t`) = t_{L} (t+t1') unterscheidet sich ebenfalls nur die Amplitude U_{K},U_{L} und auch zu einem dritten Extremwert E3 zu einen Zeitpunkt t_{K} (t+t") - t_{L} (t+t") unterscheidet sich nur die jeweilige Amplitude U_{K},U_{L}. Da nun die jeweiligen Zeitpunkte zu den jeweiligen Extremwerten E1,E2,E3 in den Wertepaaren U_{K},t_{K} bzw. U_{L},t_{L} übereinstimmen, kann man deutlich sagen, dass hier keine Alterung oder Verschleiß vorliegt, sondern nur ein Einfluss der Versorgungsspannung VCC die Amplitudenwerte U_{K},U_{L} verschoben hat.

## Patentansprüche

1. Ausgabebaugruppe (1) mit einem Ausgang (A1) zum Schalten einer Last (L), umfassend ein Schaltmittel (2), welches an den Ausgang (A1) eine Schaltspannung (U_{A}) schaltet und damit ein Laststrom (I_{L}) vom Ausgang (A1) aus durch die Last (L) fließt, aufweisend
- ein Messmittel (3) ausgestaltet zum Bereitstellen eines Überwachungs-Signalverlaufs (Sᵢ), welcher einen Signalverlauf des Laststromes (I_{L}) aufgrund der Schaltspannung (UA) abbildet,
- ein Analysemittel (4) ausgestaltet den Überwachungs-Signalverlauf (Si) mit einer die Last (L) charakterisierenden Einschaltkennlinie (K1) zumindest punktuell zu vergleichen,
- ein Diagnosemittel (5) ausgestaltet eine Wartungsmeldung (7) zu generieren, wenn der Vergleich eine vorgebbare Abweichung überschreitet,
**gekennzeichnet durch**, ein Erfassungsmittel (6), welches ausgestaltet ist bei einer erstmaligen Inbetriebnahme der Last(L) einen Anfangszustand und damit eine Individual-Einschaltkennlinie (Kᵣₑₐₗ) der Last (L) über einen vorbestimmten Erfassungszeitraum (T_{E}) mit einer vorbestimmtem Abtastrate zu erfassen, weiterhin ist das Erfassungsmittel (6) dazu ausgestaltet, für den punktuellen Vergleich aus der Individual-Einschaltkennlinie (Kᵣₑₐₗ) Wertepaare (Uₖ,tₖ) zu ermitteln und abzuspeichern, bei denen eine Steigung (m) im Verlauf der Individual-Einschaltkennlinie (Kᵣₑₐₗ) das Vorzeichen wechselt oder Null ist, wobei die Wertepaare (Uₖ,tₖ) eine Amplitude (Uₖ) und ein Zeitpunkt (tₖ) aufweisen,
das Messmittel (3) ist dann ausgestaltet ebenfalls in dem vorbestimmten Erfassungszeitraum (T_{E}) mit der vorbestimmtem Abtastrate den Überwachungs-Signalverlauf (Sᵢ) bereitzustellen, weiterhin ist das Analysemittel (4) ausgestaltet, für den punktuellen Vergleich aus dem Überwachungs-Signalverlauf (Sᵢ) aktuelle Wertepaare (Uₗ,tₗ) zu ermitteln bei denen ebenfalls eine Steigung (m) im Verlauf des Überwachungs-Signalverlaufs (Sᵢ)) das Vorzeichen wechselt oder Null ist, weiterhin ist das Analysemittel (4) dazu ausgestaltet die Wertepaare (Uₖ,tₖ) mit den aktuellen Wertepaaren (Uₗ,tₗ) hinsichtlich einer Verschiebung ihres Zeitpunktes hin zu untersuchen, und bei Überschreiten einer vorgebbaren Abweichung die Wartungsmeldung (7) zu generieren.

2. Ausgabebaugruppe (1) nach Anspruch 1, wobei das Analysemittel (4) ausgestaltet ist, eine Höhe einer Versorgungsspannung (V_{cc}) der Ausgabebaugruppe (1) zu ermitteln und bei einem Vergleich des Überwachungs-Signalverlaufs (Sᵢ) mit der Einschaltkennlinie (K1) die Höhe der Versorgungsspannung (V_{cc}) derart zu berücksichtigen, dass es bei Schwankungen in der Versorgungsspannung (V_{cc}), welche sich ebenfalls auf die Schaltspannung (U_{A}) und damit auf den Überwachungs-Signalverlauf (Sᵢ) auswirken, nicht zu einer fälschlicherweise generierten Wartungsmeldung (7) kommt.

3. Ausgabebaugruppe (1) nach einem der Ansprüche 1 oder 2, wobei das Analysemittel (4) ausgestaltet ist, in Bezug auf eine induktive Last (L) eines elektromechanischen Stellgliedes mit einer Spule und einem Anker in dem Überwachungs-Signalverlauf (Sᵢ) folgende Werte zu ermitteln, ausgehend von einem Startzeitpunkt (t0), bei welchen eine Bestromung der Spule beginnt, wird bei Erreichen eines ersten Zeitpunktes (t1), bei welchem sich der Anker bewegt, ein erster Vergleichswert (P1), bei Erreichen eines zweiten Zeitpunktes (t2), bei welchem der Anker eine Endlage erreicht, wird ein zweiter Vergleichswert (P2) ermittelt und bei Erreichen eines dritten Zeitpunktes (t3), bei welchem eine magnetische Sättigung erreicht ist, wird ein dritter Vergleichswert (P3) ermittelt.

4. Ausgabebaugruppe (1) nach Anspruch 3, wobei das Analysemittel (4) ausgestaltet ist, eine Zeitdauer (Δt) zwischen dem ersten Zeitpunkt (t1) und dem zweiten Zeitpunkt (t2) zu ermitteln und als ein Verschleißkriterium zu werten und eine Wartungsmeldung (7) zu generieren, wenn die Zeitdauer (Δt) eine vorgebbare Zeitdauer (tₙₑᵤ) überschreitet.

5. Ausgabebaugruppe (1) nach einem der Ansprüche 1 bis 4, aufweisend einen Zwischenspeicher (8) ausgestaltet zum Speichern von Überwachungs-Signalverläufen (Si) und Weiterleiten an ein übergeordnetes System.

6. Ausgabebaugruppe (1) nach einem der Ansprüche 1 bis 5, mit einem Filter (F) zur Berechnung eines geglätteten Signalverlauf, falls der Überwachungs-Signalverlaufs (Sᵢ) als gepulster Signalverlauf vorliegt.

7. Verfahren zum Betrieb einer Ausgabebaugruppe (1) nach einem der Ansprüche 1 bis 6, wobei ein Schaltmittel (2) an einem Ausgang (A1) zum Schalten einer Last (L) eine Schaltspannung (UA) schaltet und damit ein Laststrom (I_{L}) fließt,
wobei ein Überwachungs-Signalverlauf (Sᵢ) ermittelt wird, welcher einen Signalverlauf des Laststromes (I_{L}) aufgrund der Schaltspannung (UA) abbildet,
- der Überwachungs-Signalverlauf (Sᵢ) derart analysiert wird, dass er mit einer die Last (L) charakterisierenden Einschaltkennlinie (K1) zumindest punktuell verglichen wird,
- ein Diagnosemittel (5) betrieben wird, eine Wartungsmeldung (7) zu generieren, wenn der Vergleich eine vorgebbare Abweichung überschreitet,
**dadurch gekennzeichnet, dass** mittels eines Erfassungsmittels (6) bei einer erstmaligen Inbetriebnahme der Last(L) ein Anfangszustand und damit eine Individual-Einschaltkennlinie (Kᵣₑₐₗ) der Last (L) über einen vorbestimmten Erfassungszeitraum (T_{E}) mit einer vorbestimmtem Abtastrate erfasst wird, weiterhin werden für den punktuellen Vergleich aus der Individual-Einschaltkennlinie (Kᵣₑₐₗ) Wertepaare (Uₖ,tₖ) ermittelt und abgespeichert, bei denen eine Steigung (m) im Verlauf der Individual-Einschaltkennlinie (Kᵣₑₐₗ) das Vorzeichen wechselt oder Null ist, wobei die Wertepaare (Uₖ,tₖ) eine Amplitude (Uₖ) und einen Zeitpunkt (tₖ) aufweisen, mit dem Messmittel (3) wird dann ebenfalls in dem vorbestimmten Erfassungszeitraum (T_{E}) mit der vorbestimmten Abtastrate der Überwachungs-Signalverlaufs (Sᵢ) bereitgestellt, weiterhin werden für den punktuellen Vergleich aus dem Überwachungs-Signalverlauf (Sᵢ) aktuelle Wertepaare (Uₗ,tₗ) ermittelt bei denen ebenfalls eine Steigung (m) im Verlauf des Überwachungs-Signalverlaufs (Sᵢ) das Vorzeichen wechselt oder Null ist, die Wertepaare (Uₖ,tₖ) aus der Individual-Einschaltkennlinie (Kᵣₑₐₗ) werden mit den aktuellen Wertepaaren (Uₗ,tₗ) hinsichtlich einer Verschiebung ihres Zeitpunktes hin verglichen, und bei Überschreiten einer vorgebbaren Abweichung wird die Wartungsmeldung (7) generiert.

8. Verfahren nach Anspruch 7, wobei das Analysemittel (4) betrieben wird, eine Höhe einer Versorgungsspannung (V_{cc}) der Ausgabebaugruppe (1) zu ermitteln und bei einem Vergleich des Überwachungs-Signalverlaufs (Sᵢ) mit der Einschaltkennlinie (K1) die Höhe der Versorgungsspannung (V_{cc}) derart zu berücksichtigen, dass es bei Schwankungen in der Versorgungsspannung (V_{cc}), welche sich ebenfalls auf die Schaltspannung (UA) und damit auf den Überwachungs-Signalverlauf (Si) auswirken, nicht zu einer fälschlicherweise generierten Wartungsmeldung (7) kommt.

9. Verfahren nach einem der Ansprüche 7 oder 8, wobei bei einer induktiven Last(L) eines elektromechanischen Stellgliedes mit einer Spule und einem Anker in dem Überwachungs-Signalverlauf (Sᵢ) folgende Werte ermittelt werden, ausgehend von einem Startzeitpunkt (t0), bei welchem eine Bestromung der Spule beginnt, wird bei Erreichen eines ersten Zeitpunktes (t1), bei welchem sich der Anker bewegt, ein erster Vergleichswert (P1), bei Erreichen eines zweiten Zeitpunktes (t2), bei welchem der Anker eine Endlage erreicht, wird ein zweiter Vergleichswert (P2) ermittelt und bei Erreichen eines dritten Zeitpunktes (t3), bei welchem eine magnetische Sättigung erreicht ist, wird ein dritter Vergleichswert (P3) ermittelt.

10. Verfahren nach Anspruch 9, wobei eine Zeitdauer (Δt) zwischen dem ersten Zeitpunkt (t1) und dem zweiten Zeitpunkt (t2) ermittelt wird und als ein Verschleißkriterium gewertet wird und eine Wartungsmeldung (7) generiert wird, wenn die Zeitdauer (Δt) eine vorgebbare Zeitdauer (tₙₑᵤ) überschreitet.

11. Verfahren nach einem der Ansprüche 8 bis 10, wobei die Überwachungs-Signalverläufe (Sᵢ) auf der Ausgabebaugruppe (1) zwischengespeichert werden und an ein übergeordnetes System weitergegeben werden.

## Claims

1. Output module (1) having an output (A1) for switching a load (L), comprising a switching means (2) which switches a switching voltage (U_{A}) to the output (A1) and thereby causes a load current (I_{L}) to flow from the output (A1) through the load (L), having
- a measuring means (3) embodied to provide a monitoring signal profile (Sᵢ) which maps a signal profile of the load current (I_{L}) on the basis of the switching voltage (UA),
- an analysis means (4) embodied to compare, at least point-by-point, the monitoring signal profile (Si) with a switch-on characteristic curve (K1) characterising the load (L),
- a diagnostic means (5) embodied to generate a maintenance notification (7) if the comparison exceeds a specifiable deviation,
**characterised by** a detection means (6), which is embodied, on the first startup of the load (L), to detect an initial state and thus an individual switch-on characteristic curve (Kᵣₑₐₗ) of the load (L) over a predetermined detection period (T_{E}) at a predetermined sampling rate, furthermore, the detection means (6) is embodied, for the point-by-point comparison, to ascertain and store value pairs (Uₖ,tₖ) from the individual switch-on characteristic curve (Kᵣₑₐₗ) at which a gradient (m) changes sign or is equal to zero in the course of the individual switch-on characteristic curve (Kᵣₑₐₗ), wherein the value pairs (Uₖ,tₖ) have an amplitude (Uₖ) and a point in time (tₖ),
the measuring means (3) is then embodied likewise to provide the monitoring signal profile (Sᵢ) in the predetermined detection period (T_{E}) at the predetermined sampling rate, furthermore, the analysis means (4) is embodied, for the point-by-point comparison, to ascertain current value pairs (Uₗ,tₗ) from the monitoring signal profile (Sᵢ) at which a gradient (m) likewise changes sign or is equal to zero in the course of the monitoring signal profile (Sᵢ),
furthermore, the analysis means (4) is embodied to examine the value pairs (Uₖ,tₖ) with the current value pairs (Uₗ,tₗ) with regard to a shift in their point in time and to generate the maintenance notification (7) if a specifiable deviation is exceeded.

2. Output module (1) according to claim 1, wherein the analysis means (4) is embodied to ascertain a level of a supply voltage (V_{cc}) of the output module (1) and, when comparing the monitoring signal profile (Sᵢ) with the switch-on characteristic curve (K1), to take account of the level of the supply voltage (V_{cc}) in such a way that, in the event of fluctuations in the supply voltage (V_{cc}), which likewise affect the switching voltage (U_{A}) and thus the monitoring signal profile (Sᵢ), no erroneously generated maintenance notification (7) occurs.

3. Output module (1) according to one of claims 1 or 2, wherein the analysis means (4) is embodied, in relation to an inductive load (L) of an electromechanical actuator with a coil and an armature, to ascertain the following values in the monitoring signal profile (Sᵢ), starting from a starting point in time (t0) at which energisation of the coil begins, a first comparison value (P1) is ascertained when a first point in time (t1) is reached at which the armature moves, a second comparison value (P2) is ascertained when a second point in time (t2) is reached at which the armature reaches an end position and a third comparison value (P3) is ascertained when a third point in time (t3) is reached at which magnetic saturation is reached.

4. Output module (1) according to claim 3, wherein the analysis means (4) is embodied to ascertain a duration (Δt) between the first point in time (t1) and the second point in time (t2) and to evaluate this as a wear criterion and to generate a maintenance notification (7) if the duration (Δt) exceeds a specifiable duration (tₙₑᵤ).

5. Output module (1) according to one of claims 1 to 4, having a buffer memory (8) embodied to store monitoring signal profiles (Si) and forward them to a higher-level system.

6. Output module (1) according to one of claims 1 to 5, comprising a filter (F) for calculating a smoothed signal profile if the monitoring signal profile (Sᵢ) is present as a pulsed signal profile.

7. Method for operating an output module (1) according to one of claims 1 to 6, wherein a switching means (2) switches a switching voltage (UA) to an output (A1) for switching a load (L) and thereby causes a load current (I_{L}) to flow, wherein a monitoring signal profile (Sᵢ) is ascertained which maps a signal profile of the load current (I_{L}) on the basis of the switching voltage (UA),
- the monitoring signal profile (Sᵢ) is analysed in such a way that it is compared, at least point-by-point, with a switch-on characteristic curve (K1) characterising the load (L),
- a diagnostic means (5) is operated in order to generate a maintenance notification (7) if the comparison exceeds a specifiable deviation,
**characterised in that**, on a first startup of the load (L), a detection means (6) detects an initial state and thus an individual switch-on characteristic curve (Kᵣₑₐₗ) of the load (L) over a predetermined detection period (T_{E}) at a predetermined sampling rate, furthermore, for the point-by-point comparison, value pairs (Uₖ,tₖ) at which a gradient (m) changes sign or is equal to zero in the course of the individual switch-on characteristic curve (Kᵣₑₐₗ) are ascertained from the individual switch-on characteristic curve (Kᵣₑₐₗ) and stored, wherein the value pairs (Uₖ,tₖ) have an amplitude (Uₖ) and a point in time (tₖ), the measuring means (3) then likewise provides the monitoring signal profile (Sᵢ) in the predetermined detection period (T_{E}) at the predetermined sampling rate, furthermore, for the point-by-point comparison, current value pairs (Uₗ,tₗ) at which a gradient (m) likewise changes sign or is equal to zero in the course of the monitoring signal profile (Sᵢ) are ascertained from the monitoring signal profile (Sᵢ), the value pairs (Uₖ,tₖ) from the individual switch-on characteristic curve (Kᵣₑₐₗ) are compared with the current value pairs (Uₗ,tₗ) with regard to a shift in their point in time and the maintenance notification (7) is generated if a specifiable deviation is exceeded.

8. Method according to claim 7, wherein the analysis means (4) is operated in order to ascertain a level of a supply voltage (V_{cc}) of the output module (1) and, when comparing the monitoring signal profile (Sᵢ) with the switch-on characteristic curve (K1), to take account of the level of the supply voltage (V_{cc}) in such a way, that, in the event of fluctuations in the supply voltage (V_{cc}) , which likewise affect the switching voltage (UA) and thus the monitoring signal profile (Si), no erroneously generated maintenance notification (7) occurs.

9. Method according to one of claims 7 or 8, wherein, in the event of an inductive load (L) of an electromechanical actuator with a coil and an armature, the following values are ascertained in the monitoring signal profile (Sᵢ), starting from a starting point in time (t0), at which energisation of the coil begins, a first comparison value (P1) is ascertained when a first point in time (t1) is reached at which the armature moves, a second comparison value (P2) is ascertained when a second point in time (t2) is reached at which the armature reaches an end position and a third comparison value (P3) is ascertained when a third point in time (t3) is reached at which magnetic saturation is reached.

10. Method according to claim 9, wherein a duration (Δt) between the first point in time (t1) and the second point in time (t2) is ascertained and evaluated as a wear criterion, and a maintenance notification (7) is generated if the duration (Δt) exceeds a specifiable duration (tₙₑᵤ).

11. Method according to one of claims 8 to 10, wherein the monitoring signal profiles (Sᵢ) are buffered on the output module (1) and routed to a higher-level system.

## Revendications

1. Module (1) de sortie ayant une sortie (A1) pour la connexion d'une charge (L), comprenant un moyen (2) de connexion, qui applique une tension (U_{A}) de connexion à la sortie (A1) et ainsi un courant (I_{L}) de charge passe à partir de la sortie (A1) dans la charge (L), comportant
- un moyen (3) de mesure conformé pour disposer d'une courbe (Sᵢ) de signal de contrôle, qui reproduit une courbe de signal du courant (I_{L}) de charge sur la base de la tension (UA) de commutation,
- un moyen (4) d'analyse conformé pour comparer, au moins ponctuellement, la courbe (Si) de signal de contrôle à une courbe (K1) caractéristique de mise en circuit caractérisant la charge (L),
- un moyen (5) de prévision conformé pour produire un message (7) d'entretien, lorsque la comparaison dépasse un écart pouvant être donné à l'avance,
**caractérisé par** un moyen (6) de détection, qui est conformé pour, lors d'une mise en fonctionnement la première fois de la charge (L), détecter un état initial et ainsi une courbe (Kᵣₑₐₗ) caractéristique de mise en circuit individuelle de la charge (L) sur un laps (T_{E}) de temps de détection déterminé à l'avance avec un taux d'échantillonnage déterminé à l'avance, le moyen (6) de détection étant conformé en outre pour déterminer et mettre en mémoire, pour la comparaison ponctuelle à partir de la courbe (Kᵣₑₐₗ) caractéristique de mise en circuit individuelle, des paires (Uₖ, tₖ) de valeurs, pour lesquelles une pente (m) de la courbe (Kᵣₑₐₗ) caractéristique de mise en circuit individuelle change de signe ou est nulle, dans lequel les paires (Uₖ, tₖ) de valeurs ont une amplitude (Uₖ) et un instant (tₖ),
le moyen (3) de mesure est alors conformé également pour disposer également, dans le laps (T_{E}) de temps de détection déterminé à l'avance avec le taux d'échantillonnage déterminé à l'avance, de la courbe (Sᵢ) de signal de contrôle, le moyen (4) d'analyse étant conformé en outre pour déterminer, pour la comparaison ponctuelle à partir de la courbe (Sᵢ) de signal de contrôle, des paires (U₁, t₁) de valeurs en cours, pour lesquelles également une pente (m) de la courbe (Sᵢ) de signal de contrôle change de signe ou est nulle,
le moyen (4) d'analyse est en outre conformé pour examiner les paires (Uₖ, tₖ) de valeurs avec les paires (U₁, t₁) de valeurs en cours en ce qui concerne un décalage de leur instant et pour produire le message (7) d'entretien, si un écart pouvant être donné à l'avance est dépassé.

2. Module (1) de sortie suivant la revendication 1, dans lequel le moyen (4) d'analyse est conformé pour déterminer une amplitude d'une tension (V_{cc}) d'alimentation du module (1) de sortie et, lors d'une comparaison de la courbe (Sᵢ) de signal de contrôle à la courbe (K1) caractéristique de mise en circuit, prendre en compte l'amplitude de la tension (V_{cc}) d'alimentation, de manière à ce que, s'il se produit des fluctuations de la tension (V_{cc}) d'alimentation, qui retentissent également sur la tension (U_{A}) de connexion et ainsi sur la courbe (Sᵢ) de signal de contrôle, à ne pas en venir à un message (7) d'entretien produit de manière fallacieuse.

3. Module (1) de sortie suivant l'une des revendications 1 ou 2, dans lequel le moyen (4) d'analyse est conformé pour déterminer, en relation avec une charge (L) inductive d'un élément d'actionnement électromécanique ayant une bobine et un induit, des valeurs suivantes dans la courbe (Sᵢ) de signal de contrôle, en partant d'un instant (t0) de début, où commence une alimentation en courant de la bobine, on déterminera, lorsqu'un premier instant (t1) sera atteint où l'induit se déplace, une première valeur (P1) de comparaison, lorsqu'on atteindra un deuxième instant (t2) où l'induit atteint une position de fin de course, on déterminera une deuxième valeur (P2) de comparaison et lorsque l'on atteindra un troisième instant (t3) où une saturation magnétique est atteinte, on déterminera une troisième valeur (P3) de comparaison.

4. Module (1) de sortie suivant la revendication 3, dans lequel le moyen (4) d'analyse est conformé pour déterminer une durée (Δt) entre le premier instant (t1) et le deuxième instant (t2) et pour évaluer comme critère d'usure et donner un message (7) d'entretien, si la durée (Δt) dépasse une durée (tₙₑᵤ) pouvant être donnée à l'avance.

5. Module (1) de sortie suivant l'une des revendications 1 à 4, comportant une mémoire (8) intermédiaire conformée pour mettre en mémoire des courbes (Si) de signal de contrôle et les acheminer à un système supérieur hiérarchiquement.

6. Module (1) de sortie suivant l'une des revendications 1 à 5, comprenant un filtre (F) pour le calcul d'une courbe de signal lissée, si la courbe (Sᵢ) de signal de contrôle se présente sous la forme d'une courbe de signal pulsée.

7. Procédé pour faire fonctionner un module (1) de sortie suivant l'une des revendications 1 à 6, dans lequel un moyen (2) de connexion applique une tension (UA) de connexion à une sortie (A1) pour la connexion d'une charge (L) et il passe ainsi un courant (I_{L}) de charge,
dans lequel on détermine une courbe (Sᵢ) de signal de contrôle, qui représente une courbe de signal du courant (I_{L}) de charge sur la base de la tension (UA) de connexion,
- on analyse la courbe (Sᵢ) de signal de contrôle de manière à la comparer au moins ponctuellement à une courbe (K1) caractéristique de mise en circuit caractérisant la charge (L),
- on fait fonctionner un moyen (5) de prévision pour donner un message (7) d'entretien, si la comparaison dépasse un écart pouvant être donné à l'avance,
**caractérisé en ce que**, au moyen d'un moyen (6) de détection, on détecte lors d'une mise en fonctionnement, pour la première fois, de la charge (L), un état initial et ainsi une courbe (Kᵣₑₐₗ) caractéristique de mise en circuit individuelle de la charge (L) sur un laps (T_{E}) de temps de détection déterminé à l'avance avec un taux d'échantillonnage déterminé à l'avance, en outre, on détermine et on mémorise, pour la comparaison ponctuelle à partir de la courbe (Kᵣₑₐₗ) caractéristique de mise en circuit individuelle des paires (Uₖ, tₖ) de valeurs, pour lesquelles une pente (m) de la courbe (Kᵣₑₐₗ) caractéristique de mise en circuit individuelle change de signe ou est nulle, dans lequel les paires (Uₖ, tₖ) de valeurs ont une amplitude (Uₖ) et un instant (tₖ), par le moyen (3) de mesure on dispose également, dans le laps (T_{E}) de temps de détection déterminé à l'avance avec le taux d'échantillonnage déterminé à l'avance, de la courbe (Sᵢ) de signal de contrôle, on détermine en outre, pour la comparaison ponctuelle à partir de la courbe (Sᵢ) de signal de contrôle des paires (U₁, t₁) de valeurs en cours, pour lesquelles également une pente (m) de la courbe (Sᵢ) de signal de contrôle change de signe ou est nulle, on compare les paires (Uₖ, tₖ) de valeurs à partir de la courbe (Kᵣₑₐₗ) caractéristique de mise en circuit individuelle aux paires (U₁, t₁) de valeurs en cours en ce qui concerne un décalage de leur instant et, si l'on constate un écart pouvant être donné à l'avance, on donne le message (7) d'entretien.

8. Procédé suivant la revendication 7, dans lequel on fait fonctionner le moyen (4) d'analyse pour déterminer une amplitude d'une tension (V_{cc}) d'alimentation du module (1) de sortie et, lors d'une comparaison de la courbe (Sᵢ) de signal de contrôle à la courbe (K1) caractéristique de mise en circuit, prendre en compte l'amplitude de la tension (V_{cc}) d'alimentation, de manière à ce que, s'il se produit des fluctuations de la tension (V_{cc}) d'alimentation, qui retentissent également sur la tension (UA) de connexion et ainsi sur la courbe (Si) de signal de contrôle, à ne pas en venir à un message (7) d'entretien produit de manière fallacieuse.

9. Procédé suivant l'une des revendications 7 ou 8, dans lequel pour une charge (L) inductive d'un élément d'actionnement électromécanique ayant une bobine et un induit, des valeurs suivantes dans la courbe (Sᵢ) de signal de contrôle en partant d'un instant (t0) de début où commence une alimentation en courant de la bobine, on déterminera, lorsqu'un premier instant (t1) sera atteint où l'induit se déplace, une première valeur (P1) de comparaison, lorsqu'on atteindra un deuxième instant (t2) où l'induit atteint une position de fin de course, on déterminera une deuxième valeur (P2) de comparaison et lorsque l'on atteindra un troisième instant (t3) où une saturation magnétique est atteinte, on déterminera une troisième valeur (P3) de comparaison.

10. Procédé suivant la revendication 9, dans lequel on détermine une durée (Δt) entre le premier instant (t1) et le deuxième instant (t2) et on évalue comme critère d'usure et on donne un message (7) d'entretien, si la durée (Δt) dépasse une durée (tₙₑᵤ) pouvant être donnée à l'avance.

11. Procédé suivant l'une des revendications 8 à 10, dans lequel on met en mémoire tampon les courbes (Sᵢ) de signal de contrôle sur le module (1) de sortie et on les achemine à un système supérieur hiérarchiquement.
